# EUROPÄISCHE PATENTSCHRIFT

(11) **EP 1 920 264 B1**
(45) Veröffentlichungstag und Bekanntmachung des Hinweises auf die Patenterteilung: **27.01.2010**
(21) Anmeldenummer: 06777559.3
(22) Anmeldetag: 04.07.2006
(51) Int. Cl.: G01R 31/36

(54) **BATTERIESENSOREINHEIT**
BATTERY SENSOR UNIT
CAPTEUR DE BATTERIE

(30) Priorität: 19.08.2005 DE 102005039587
(43) Veröffentlichungstag der Anmeldung: 14.05.2008
(73) Patentinhaber: ROBERT BOSCH GMBH, 70442 Stuttgart (DE)
(72) Erfinder: WENGER, Christoph, 70825 Korntal-Muenchingen (DE)
(86) Internationale Anmeldenummer: PCT/EP2006/063828
(87) Internationale Veröffentlichungsnummer: WO 2007/020129

(56) Entgegenhaltungen:
- EP-A- 1 435 524
- US-A- 5 818 234
- US-B1- 6 218 805

## Beschreibung

### Stand der Technik

Die Erfindung betrifft eine Batteriesensoreinheit mit einer Befestigungsvorrichtung und einer Messstrecke sowie ein Verfahren zur Verbindung einer Befestigungsvorrichtung einer Batteriesensoreinheit mit einer Messstrecke nach der Gattung der unabhängigen Ansprüche.

Zur Batteriezustandserkennung von Batterien in Kraftfahrzeugen werden in der Regel die Größen Temperatur, Strom und/oder Spannung erfasst und mittels geeigneter Algorithmen verarbeitet. Dabei kommt typischerweise in Mikrocontroller oder eine entsprechende Rechnereinheit zum Einsatz. Zur Stromerfassung dienen im Allgemeinen Messshunts und induktive Stromsensoren, wie Kompensationssensoren, Fluxgate- oder Hallelemente.

Aus der EP-A 1 435 524 ist eine Batteriesensorvorrichtung mit einer direkt an einen Pol einer Kraftfahrzeugbatterie anschließbaren Befestigungsvorrichtung bekannt, wobei die Befestigungsvorrichtung und ein Batteriesensor zu einer integrierten Baueinheit zusammengefasst sind. Die Batteriesensorvorrichtung ist in Form und Größe an übliche Batteriepolwannen angepasst. Darüber hinaus besteht der Batteriesensor aus einem planaren Messshunt und einer Elektronikeinheit, wobei der Messshunt als Widerstandselement mit zwei als mechanische Träger ausgebildeten Widerstandsanschlüssen ausgestaltet ist.

Aus der US 5,818,234 ist bereits ein Batterietester bekannt. Dieser überwacht unabhängig sowohl die Temperatur einer Last wie auch die Leistung, die von der Last verbraucht wird. Abgeleitet von diesen Signalen wird der Benutzer gewarnt, wenn das System bestimmte Grenzwerte überschreitet.

### Vorteile der Erfindung

Gegenüber dem Stand der Technik weist die erfindungsgemäße Batteriesensoreinheit mit einer Befestigungsvorrichtung zur Befestigung der Batteriesensoreinheit an einen Kontakt einer Batterie, insbesondere einer Kraftfahrzeugbatterie, und mit einer Messstrecke zur Erfassung des Zustands der Batterie, wobei die Messstrecke und die Befestigungsvorrichtung zu einer integralen Baueinheit zusammengefasst sind, den Vorteil auf, dass keine wesentlichen, konstruktiven Modifikationen mehr für eine Änderung der Kabelabgangsrichtung notwendig sind. Zu diesem Zweck ist vorgesehen, dass die Messstrecke zylinderförmig ausgebildet ist. Die Geometrie der Messstrecke gewährleistet damit eine sehr hohe mechanische Festigkeit der Batteriesensoreinheit aufgrund des einsetzbaren Schweißverfahrens bzw. einer in alle Richtungen der Messstrecke nahezu konstanten Biegefestigkeit. Weiterhin ergibt sich hieraus ein deutlicher Kostenvorteil gegenüber der herkömmlichen Anschluss- und Verbindungstechnik.

In vorteilhafter Weise ist die Messstrecke der Batteriesensoreinheit auf einer ersten Seite mit der Befestigungsvorrichtung verschweißt und auf einer anderen, der ersten Seite gegenüber liegenden Seite mit einer Kabelaufnahme für ein Batteriekabel versehen. Dabei kann die Kabelaufnahme mit dem Batteriekabel mittels Verlöten, Kaltverschweißen oder einer entsprechenden Verbindungstechnik verbunden werden, während sich für die Verbindung zwischen der Befestigungsvorrichtung und der Messstrecke einerseits sowie der Messstrecke und der Kabelaufnahme andererseits ein Reibschweißverfahren anbietet.

Um die Schweißverbindung und/oder das thermoelektrische Verhalten der Batteriesensoreinheit zu optimieren, ist in einer alternativen Ausgestaltung vorgesehen, zwischen der Messstrecke und der Befestigungsvorrichtung eine Kupferschicht anzuordnen. Die Messstrecke selbst besteht aus einem Widerstandsmaterial, insbesondere Manganin, und ist als ein Messshunt ausgebildet. Darüber hinaus besteht die Möglichkeit, entweder die gesamte Batteriesensoreinheit aus einem Widerstandsmaterial, insbesondere Manganin, herzustellen oder aber die Befestigungsvorrichtung sowie die Kabelaufnahme im Unterschied zur Messstrecke in Kupfer oder einem entsprechenden Material mit sehr guter elektrischer Leitfähigkeit auszubilden.

In einer vorteilhaften Ausgestaltung bietet sich infolge der sehr kompakten Bauweise an, dass die Ausmaße der Batteriesensoreinheit im Wesentlichen die Ausmaße einer Kontaktnische der Batterie nicht überschreiten, so dass die Batteriesensoreinheit weitestgehend oder vollständig in die Kontaktnische passt und zudem keine konstruktiven Modifikationen für die verschiedenen Kabelabgangsrichtungen erforderlich sind. Dabei umfassen die genannten Ausmaße zumindest eine Längen- und Breitenausdehnung.

Weitere Vorteile der Erfindung ergeben sich durch die in den abhängigen Ansprüchen angegebenen Merkmale sowie aus der Zeichnung und der nachfolgenden Beschreibung.

### Zeichnung

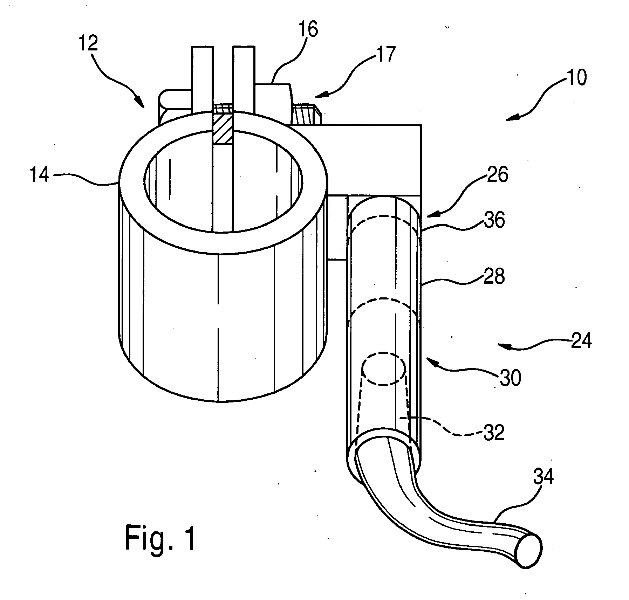

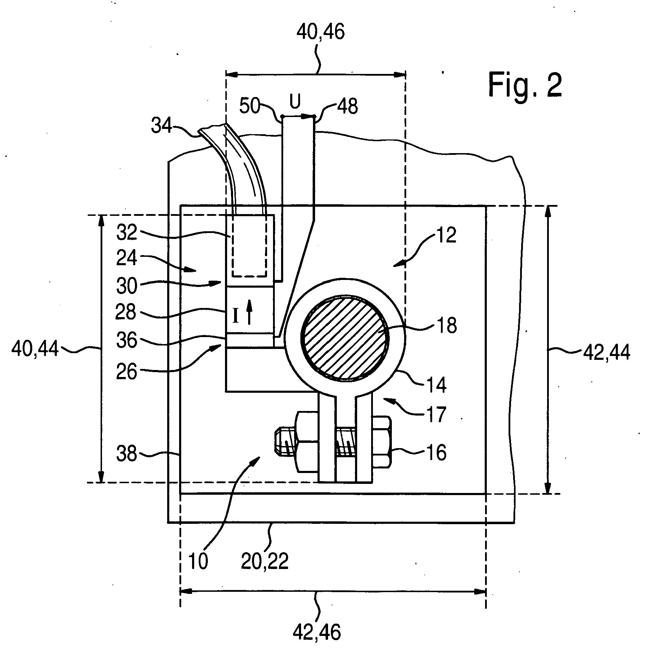

Die Erfindung wird im Folgenden anhand der Figuren 1 und 2 beispielhaft erläutert, wobei gleiche Bezugszeichen in den Figuren auf gleiche Bestandteile mit einer gleichen Funktionsweise hindeuten. Es zeigen
Fig. 1: eine erste Ansicht eines Ausführungsbeispiels der erfindungsgemäßen Batteriesensoreinheit und
Fig. 2: eine zweite Ansicht des Ausführungsbeispiels der erfindungsgemäßen Batteriesensoreinheit.

### Beschreibung

In Figur 1 ist eine erste Ansicht eines Ausführungsbeispiels der erfindungsgemäßen Batteriesensoreinheit 10 gezeigt. Die Batteriesensoreinheit 10 besteht zum Einen aus einer Befestigungsvorrichtung 12, die mittels einer auf einen Klemmkörper 14 wirkenden Klemmschraube 16 in Gestalt einer Polklemme 17 mit einem Kontakt 18 bzw. Pol einer Batterie 20, insbesondere einer Kraftfahrzeugbatterie 22, (siehe Figur 2) verbunden werden kann. Zum Anderen besteht die Batteriesensoreinheit 10 aus einer Messstrecke 24, die in einer integralen Baueinheit auf einer ersten Seite 26 mit der Befestigungsvorrichtung 12 zusammengefasst ist. Aufgrund der zylinderförmigen Ausbildung der Messstrecke 24 ergibt sich die Möglichkeit einer kostengünstigen, direkten Reibverschweißung zwischen Messstrecke 24 und Befestigungsvorrichtung 12. Ebenso sind jedoch auch andere Schweißverbindungen denkbar.

Die Messstrecke 24 ist als ein Messshunt 28 ausgebildet und besteht aus einem Widerstandsmaterial, insbesondere Manganin. Während die erste Seite 26 mit der Befestigungsvorrichtung 12 verschweißt ist, weist eine andere, der ersten Seite 26 gegenüber liegende Seite 30 eine Kabelaufnahme 32 für ein Batteriekabel 34 auf, die entweder aus Kupfer oder wie der Messshunt 28 aus einem Widerstandsmaterial bestehen kann und ebenfalls mit der Messstrecke 24 verschweißt ist.

Um die Schweißverbindung auf der ersten Seite 26 und/oder das thermoelektrische Verhalten der Batteriesensoreinheit 10 zu optimieren, ist zwischen der Messstrecke 24 und der Befestigungsvorrichtung 12 eine Kupferschicht 36 angeordnet. Dies ist insbesondere dann von Vorteil, wenn nicht nur die Messstrecke 24 sondern auch die Befestigungsvorrichtung 12 aus Manganin oder einem anderen Widerstandsmaterial hergestellt sind. Alternativ kann aber auch auf die Kupferschicht 36 verzichtet werden, so dass die gesamte Batteriesensoreinheit 10 inklusive der Kabelaufnahme 32 aus einem Widerstandsmaterial besteht. Ist die Befestigungseinheit 12 dagegen aus Kupfer gefertigt, so ist eine Verwendung der Kupferschicht 36 ohnehin nicht erforderlich.

Figur 2 zeigt eine Draufsicht des Ausführungsbeispiels der erfindungsgemäßen Batteriesensoreinheit 10, deren übrige Bezugszeichen mit denen von Figur 1 übereinstimmen. Die Batteriesensoreinheit 10 ist mittels des Klemmkörpers 14, der durch die Klemmschraube 16 verengt werden kann, mit dem in eine Kontaktnische 38 oder Polnische eingelassenen Kontakt 18 bzw. Pol der Batterie 20 verbindbar. Aufgrund der zylinderförmigen Ausbildung der Messstrecke 24 ist eine sehr kompakte Bauform der Batteriesensoreinheit 10 möglich, so dass deren Ausmaße 40 in vorteilhafter Weise die Ausmaße 42, insbesondere eine Längenausdehnung 44 und eine Breitenausdehnung 46, der Kontaktnische 38 im Wesentlichen nicht überschreiten.

Um den Zustand der Batterie 20 zu erfassen, wird über den Messshunt 28 eine Batteriespannung U infolge eines fließenden Batteriestroms I an einem ersten und zweiten Messabgriff 48 bzw. 50 gemessen und an eine nicht gezeigte Rechnereinheit, beispielsweise einen Mikrocontroller, zur Auswertung übergeben. Die Messabgriffe 48 und 50 können dabei an die dem Messshunt 28 angrenzenden Bereiche der Kabelaufnahme 32 und der Befestigungsvorrichtung 12 bzw. an der Kupferschicht 36 oder mit einem definierten Abstand am Messshunt 28 angebracht sein.

Es sei abschließend noch darauf hingewiesen, dass das gezeigte Ausführungsbeispiel weder auf die Figuren 1 und 2 noch auf die gezeigte Form der Befestigungsvorrichtung 12 bzw. der verwendeten Klemmschraube 16 sowie der Ausgestaltung der Kabelaufnahme 32 beschränkt ist. So ist beispielsweise ohne Einschränkung der Erfindung eine Abweichung der relativen Größenverhältnisse zwischen Messshunt 28 und Kabelaufnahme 32 bzw. Messstrecke 24 und Befestigungsvorrichtung 12 denkbar.

## Patentansprüche

1. Batteriesensoreinheit (10) mit einer Befestigungsvorrichtung (12) zur Befestigung der Batteriesensoreinheit (10) an einen Kontakt (18) einer Batterie (20), insbesondere einer Kraftfahrzeugbatterie (22), und mit einer Messstrecke (24) zur Erfassung des Zustands der Batterie (20) wobei die Messstrecke (24) als ein Messshunt (28) ausgebildet ist und, wobei die Messstrecke (24) und die Befestigungsvorrichtung (12) zu einer integralen Baueinheit zusammengefasst sind, wobei die Messstrecke (24) zylinderförmig ausgebildet ist, **dadurch gekennzeichnet, dass** die Messstrecke (24) auf einer ersten Seite (26) mit der Befestigungsvorrichtung (12) verschweißt ist und auf einer anderen, der ersten Seite (26) gegenüber liegenden Seite (30) eine Kabelaufnahme (32) für ein Batteriekabel (34) aufweist.

2. Batteriesensoreinheit (10) nach Anspruch 1, **dadurch gekennzeichnet, dass** die Messstrecke (24) aus einem Widerstandsmaterial, insbesondere Manganin, besteht.

3. Batteriesensoreinheit (10) nach einem der vorhergehenden Ansprüche, **dadurch gekennzeichnet, dass** zwischen der Messstrecke (24) und der Befestigungsvorrichtung (12) eine Kupferschicht (36) angeordnet ist.

4. Batteriesensoreinheit (10) nach einem der vorhergehenden Ansprüche, **dadurch gekennzeichnet, dass** die Befestigungsvorrichtung (12) eine Polklemme (17) ist.

5. Batteriesensoreinheit (10) nach Anspruch 1, **dadurch gekennzeichnet, dass** die gesamte Batteriesensoreinheit (10) aus einem Widerstandsmaterial, insbesondere Manganin, besteht.

6. Batteriesensoreinheit (10) nach einem der vorhergehenden Ansprüche, **gekennzeichnet durch** Ausmaße (40), die im Wesentlichen die Ausmaße (42) einer Kontaktnische (38) der Batterie (20) nicht überschreiten.

7. Batteriesensoreinheit (10) nach Anspruch 5, **dadurch gekennzeichnet, dass** die Ausmaße (40) zumindest eine Längenausdehnung (44) und eine Breitenausdehnung (46) umfassen.

8. Verfahren zur Verbindung einer Befestigungsvorrichtung (12) einer Batteriesensoreinheit (10) mit einer als Messhunt (28) ausgebildeten Messstrecke (24), wobei die Messstrecke (24) zylinderförmig ausgebildet ist und auf einer ersten Seite (26) mit der Befestigungsvorrichtung (12) in einer integralen Baueinheit verschweißt wird, **dadurch gekennzeichnet, dass** die Messstrecke (24) auf einer weiteren, der ersten Seite (26) gegenüber liegenden Seite (30) eine Kabelaufnahme (32) aufweist, die mit einem Batteriekabel (34) verbunden wird.

9. Verfahren nach Anspruch 9, **dadurch gekennzeichnet, dass** die Messtrecke (24) und die Befestigungsvorrichtung (12) durch Reibschweißen miteinander verbunden werden.

10. Verfahren nach einem der vorherigen Ansprüche 8 oder 9, **dadurch gekennzeichnet, dass** zwischen der Messstrecke (24) und der Befestigungsvorrichtung (12) eine Kupferschicht (36) eingefügt wird.

11. Verfahren nach einem der vorhergehenden Ansprüche 8 bis 10, **dadurch gekennzeichnet, dass** die Befestigungsvorrichtung (12) eine Polklemme (17) ist.

## Claims

1. Battery sensor unit (10) having a fastening apparatus (12) for fastening the battery sensor unit (10) to a contact (18) of a battery (20), in particular a motor vehicle battery (22), and having a measurement section (24) for detecting the state of the battery (20), the measurement section (24) being in the form of a measurement shunt (28) and the measurement section (24) and the fastening apparatus (12) being combined to form an integral structural unit, the measurement section (24) being cylindrical, **characterized in that** the measurement section (24) is welded to the fastening apparatus (12) on a first side (26) and has a cable holder (32) for a battery cable (34) on another side (30) which is opposite the first side (26).

2. Battery sensor unit (10) according to Claim 1, **characterized in that** the measurement section (24) is composed of a resistance material, in particular Manganin.

3. Battery sensor unit (10) according to one of the preceding claims, **characterized in that** a copper layer (36) is arranged between the measurement section (24) and the fastening apparatus (12).

4. Battery sensor unit (10) according to one of the preceding claims, **characterized in that** the fastening apparatus (12) is a pole terminal (17).

5. Battery sensor unit (10) according to Claim 1, **characterized in that** the entire battery sensor unit (10) is composed of a resistance material, in particular Manganin.

6. Battery sensor unit (10) according to one of the preceding claims, **characterized by** dimensions (40) which essentially do not exceed the dimensions (42) of a contact niche (38) of the battery (20).

7. Battery sensor unit (10) according to Claim 5, **characterized in that** the dimensions (40) comprise at least a length extent (44) and a width extent (46).

8. Method for connecting a fastening apparatus (12) of a battery sensor unit (10) to a measurement section (24) which is in the form of a measurement shunt (28), the measurement section (24) being cylindrical and being welded to the fastening apparatus (12) in an integral structural unit on a first side (26), **characterized in that** the measurement section (24) has a cable holder (32), which is connected to a battery cable (34), on a further side (30) which is opposite the first side (26).

9. Method according to Claim 8, **characterized in that** the measurement section (24) and the fastening apparatus (12) are connected to one another by means of friction welding.

10. Method according to either of the preceding Claims 8 and 9, **characterized in that** a copper layer (36) is inserted between the measurement section (24) and the fastening apparatus (12).

11. Method according to one of the preceding Claims 8 to 10, **characterized in that** the fastening apparatus (12) is a pole terminal (17).

## Revendications

1. Unité (10) de détecteur de batterie qui présente:
un dispositif de fixation (12) qui fixe l'unité (10) de détecteur de batterie sur un contact (18) d'une batterie (20), en particulier d'une batterie (22) pour véhicule automobile et
une longueur de mesure (24) qui saisit l'état de la batterie (20),
la longueur de mesure (24) étant configurée comme pont de mesure (28),
la longueur de mesure (24) et le dispositif de fixation (12) étant réunis en un module intégré et la longueur de mesure (24) ayant une configuration cylindrique,
**caractérisée en ce que**
la longueur de mesure (24) est soudée sur un premier côté (26) au dispositif de fixation (12) et présente un logement (32) pour un câble (34) de batterie sur un autre côté (30) opposé au premier côté (26) .

2. Unité (10) de détecteur de batterie selon la revendication 1, **caractérisée en ce que** la longueur de mesure (24) est constituée d'un matériau de résistance et en particulier de manganine.

3. Unité (10) de détecteur de batterie selon l'une des revendications précédentes, **caractérisée en ce qu'**une couche de cuivre (36) est placée entre la longueur de mesure (24) et le dispositif de fixation (12).

4. Unité (10) de détecteur de batterie selon l'une des revendications précédentes, **caractérisée en ce que** le dispositif de fixation (12) est une pince de pôle (17).

5. Unité (10) de détecteur de batterie selon la revendication 1, **caractérisée en ce que** la totalité de l'unité (10) de détecteur de batterie est constituée d'un matériau de résistance et en particulier de manganine.

6. Unité (10) de détecteur de batterie selon l'une des revendications précédentes, **caractérisée en ce que** ses dimensions (40) ne dépassent essentiellement pas les dimensions (42) d'une niche de contact (38) de la batterie (20).

7. Unité (10) de détecteur de batterie selon la revendication 5, **caractérisée en ce que** les dimensions (40) comprennent au moins une extension longitudinale (44) et une extension en largeur (46).

8. Procédé pour relier un dispositif de fixation (12) d'une unité (10) de détecteur de batterie à une longueur de mesure (24) configurée comme pont de mesure (28), la longueur de mesure (24) ayant une configuration cylindrique et étant soudée sur un premier côté (26) au dispositif de fixation (12) de manière à former un composant intégré,
**caractérisé en ce que**
sur un autre côté (30) opposé au premier côté (26), la longueur de mesure (24) présente un logement de câble (32) relié à un câble de batterie (34).

9. Procédé selon la revendication 9, **caractérisé en ce que** la longueur de mesure (24) et le dispositif de fixation (12) sont reliés l'un à l'autre par soudage par friction.

10. Procédé selon l'une des revendications 8 ou 9 qui précèdent, **caractérisé en ce qu'**une couche de cuivre (36) est insérée entre la longueur de mesure (24) et le dispositif de fixation (12).

11. Procédé selon l'une des revendications 8 à 10 qui précèdent, **caractérisé en ce que** le dispositif de fixation (12) est une pince de pôle (17).
